# FASCICULE DE BREVET EUROPEEN

(11) **EP 0 518 273 B1**
(45) Date de publication et mention de la délivrance du brevet: **06.09.1995**
(21) Numéro de dépôt: 92109716.8
(22) Date de dépôt: 10.06.1992
(51) Int. Cl.: H01L 39/24

(54) **Procédé de réalisation par fibrage d'une fibre supraconductrice à haute température critique et fibre obtenue par ce procédé**
Verfahren zur Herstellung einer Hochtemperatur-supraleitenden Faser durch Zerfasern und eine nach diesen Verfahren hergestellte Faser
Method of making a high temperature superconductive fibre by drawing and by this method obtained fibre

(30) Priorité: 10.06.1991 FR 9107028
(43) Date de publication de la demande: 16.12.1992
(73) Titulaire: ALCATEL ALSTHOM COMPAGNIE GENERALE D'ELECTRICITE, 75382 Paris Cédex 08 (FR)
(72) Inventeur: Bobo, Jean-Claude, F-78120 Orphin (FR); Wicker, Alain, F-75013 Paris (FR)
(74) Mandataire: Weinmiller, Jürgen

(56) Documents cités:
- EP-A- 0 369 464
- PATENT ABSTRACTS OF JAPAN vol. 13, no. 571 (E-862)18 Décembre 1989 & JP-A-1 239 713

## Description

La présente invention concerne un procédé de réalisation par fibrage d'une fibre supraconductrice à haute température critique en un matériau de la famille Bi-Sr-Ca-Cu-O.

Plusieurs auteurs ont déjà évoqué de tels procédés.

Dans l'article "Preparation of Bi_{1.5} Sr Ca Cu₂ Oₓ glass fibers using melt-quenched glasses" par M.Onishi et al - Japanese Journal of Applied Physics - vol 28 n° 12 - December 1989 - pp. L 2204 - L 2206, on décrit l'obtention d'une fibre plate de longueur 120 cm, de largeur comprise entre 200 et 1000 µm et d'épaisseur comprise entre 25 et 60 µm. Pour cela on prépare une préforme plate de longueur 20 mm, de largeur 10 mm et d'épaisseur 20 mm, par fusion des matières premières dans un creuset, trempe et recuit. On suspend cette préforme avec un poids à son extrémité dans un four et on réalise le fibrage. Les propriétés supraconductrices ne sont pas obtenues mais l'article indique qu'il faudrait prévoir un recuit au dessus de 797°C.

Dans l'article "Thermal stability and fiber drawing in Biₓ Pb_{y} Sr₂ Ca₂ Cu₃ O_{z} glasses" par Takayuki Komatsu et al -Journal of Non-Crystalline Solids 126 (1990) 273-276, on étudie diverses compositions correspondant à 1.6 ≦ x ≦ 4.0 et 0.2 ≦ y ≦ 1.6 et on indique qu'il est possible de fibrer un verre de composition Bi_{2.4} Pb_{0.5} Sr₂ Ca₂ Cu₃ O_{z} ou Bi_{2.7} Pb_{0.4} Sr₂ Ca₂ Cu₃ O_{z}.

On fond les matières premières dans un creuset de platine entre 1150°C et 1250°C ; on coule et on trempe le matériau par pressage sur une plaque métallique ; on le recuit vers 200 à 300° C et on obtient une préforme en forme de plaque.
On suspend la préforme avec un poids à son extrémité basse dans un four chauffé entre 550°C et 600°C et on réalise le fibrage. Les fibres obtenues ont une longueur de 50 cm, une largeur comprise entre 100 et 200 µm et une épaisseur de 20 µm. Ces fibres ne sont pas supraconductrices et il faut procéder à un recuit à 840°C pendant 100 heures pour obtenir une supraconductivité à T_{c} = 84K. Les auteurs indiquent que des conditions optimales de recuit pourraient conduire à une température T_{c} supérieure à 100K ; mais on constate que, si l'on accroît la température ou la durée du recuit, on risque de volatiliser le plomb et de déstabiliser la phase supraconductrice.

L'article "Bi-Pb-Sr-Ca-Cu-O superconducting Fibers Drawn from Melt- Quenched Glass Preforms" par M. Onishi et al - Japanese Journal of Applied Physics Vol 29, No 1 - January 1990 pp. L 64 - L 66,
propose un procédé analogue au procédé précédent pour une composition de type Bi_{1.6} Pb_{0.4} Sr₂ Ca₂ Cu₃ O_{z} dite phase 2223. Il insiste sur le fait que la température critique croît lorsque l'on accroît la température de recuit de la fibre obtenue (par exemple 240 heures dans l'air à 860°C). Le résultat optimal mentionné est relatif à une fibre à la température critique T_{c} = 68K dont le matériau présente les inconvénients suivants :
- une perte du plomb qui sert de stabilisant à la phase 2223 dont la température critique T_{c} est de 110K.
- une structure poreuse
- pas de texturation.

La présente invention a pour but de réaliser par fibrage une fibre en un matériau de composition Biₓ Pb_{y} Sr₂ Ca₂ Cu₃ O_{z} dont la température critique atteigne une valeur optimale, au moins supérieure à 90K.

La présente invention a pour objet un procédé de réalisation par fibrage d'une fibre supraconductrice à haute température critique en un matériau de la famille Biₓ Pb_{y} Sr₂ Ca₂ Cu₃ O_{z} avec 1,9 ≦ x+y ≦ 2,3, procédé selon lequel on réalise une préforme, un fibrage et un recuit sous air de la fibre obtenue, et caractérisé par le fait que ladite préforme est constituée d'un bloc en matériau vitreux de formule Biₓ Pb_{y} Sr₂ Ca₂ Cu₃ O_{z} avec 1,9 ≦ x+y ≦ 2,3 et d'un tube entourant ledit bloc en un matériau vitreux de formule Bi_{x′} Sr₂ Ca₁ Cu₂ O_{z}, avec 1,5 ≦ x′ ≦ 2,2.

Le recuit sous air peut être mené à 840°C pendant 200 heures.

La présente invention a également pour objet une fibre supraconductrice obtenue par le procédé précédent, caractérisée par le fait qu'elle comprend :
- un coeur en matériau supraconducteur à une température critique supérieure à 90K, dont la formule est Biₓ Pb_{y} Sr₂ Ca₂ Cu₃ O_{z} avec 1,9 ≦ x+y ≦ 2,3,
- une gaine en matériau supraconducteur à une température critique inférieure à 77K et dont la formule est Bi_{x′} Sr₂ Ca₁ Cu₂ O_{z′} avec 1 5 ≦ x′ ≦ 2,2.

La présence de la gaine permet d'assurer, lors du recuit, le maintien du plomb dans le coeur de la fibre et la stabilisation de la phase 2223.

En outre il faut noter que la valeur du coefficient de dilatation moyen entre 20°C et 600°C du matériau de la gaine est de 13.10⁻⁵/°C, tandis que celui du matériau du coeur est estimé à 10.10⁻⁵/°C. Par conséquent lors du refroidissement de la fibre, cette différence entre les coefficients de dilatation conduit à un effet de texturation mécanique, favorable aux propriétés de transport du courant supraconducteur dans le coeur.

Par ailleurs, le fait que le coeur ait une température critique supérieure à 90K, et que la gaine ait une température critique inférieure à 77K, permet d'isoler électriquement les fibres entre elles lors d'une juxtaposition éventuelle. Le procédé selon l'invention permet par la seule opération de fibrage de réaliser une fibre supraconductrice électriquement isolée.

D'autres caractéristiques et avantages de la présente invention apparaîtront au cours de la description suivante d'un mode de réalisation donné à titre illustratif mais nullement limitatif. Dans le dessin annexé :
- La figure 1 montre très schématiquement une préforme mise en oeuvre dans le procédé selon l'invention.
- La figure 2 montre en coupe agrandie une fibre obtenue par le procédé selon l'invention.

On mélange Bi₂O₃ + Pb₃O₄ + SrCO₃ + CaCO₃ + CuO dans les proportions stoechiométriques suivantes :
Bi - Pb - Sr - Ca - Cu.
1,6 - 0,4 - 2 - 2 - 3

Le mélange (5g environ) est fondu dans un creuset de platine à 1150°C pendant 30 minutes. On coule le liquide dans un moule en laiton refroidi. On obtient un rondin de matériau vitreux de diamètre environ 4 mm et de longueur 50 mm, ci-après appelé bloc 1. Ce bloc 1 subit ensuite un recuit de relaxation vers 250°C pendant 12 h.

On mélange Bi₂O₃ + SrCO₃ + CaCO₃ + CuO dans les proportions stoechiométriques suivantes :
Bi - Sr - Ca - Cu.
2 - 2 - 1 - 2

Ce mélange (5g environ) est fondu dans un creuset de platine à 1150°C pendant 30 minutes. On coule le liquide obtenu dans un moule en laiton refroidi dont la forme tubulaire permet d'obtenir un tube 2 de matériau vitreux de diamètre extérieur 6 mm, de diamètre intérieur 4 mm et de longueur 50 mm environ. Ce tube 2 subit ensuite un recuit de relaxation vers 250°C pendant 12 h.

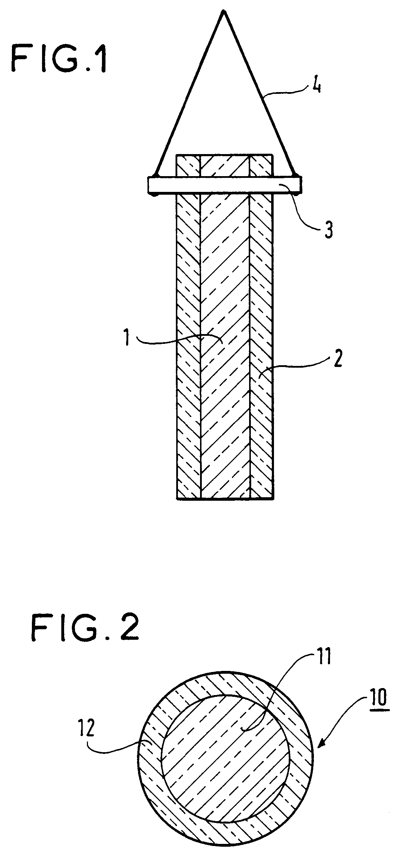

On suspend l'ensemble bloc 1 dans tube 2 au moyen d'une goupille 3 et d'un fil 4 en platine (fig.1) dans un four non illustré chauffé à 550°C. L'extrémité de l'ensemble commence à fondre et à s'allonger. On obtient ainsi une fibre 10 avec un coeur 11 et une gaine 12 dont la structure est présentée sur la figure 2. Le diamètre extérieur de la gaine 12 est d'environ 120 µm tandis que le diamètre du coeur 11 est d'environ 80 µm.

Cette fibre est ensuite recuite pendant 200 h à 840°C sous air, on obtient ainsi une fibre supraconductrice dont le matériau de gaine possède une température critique de 71K et dont le matériau de coeur possède une température critique de 94K.

Bien entendu l'invention n'est pas limitée au mode de réalisation qui vient d'être décrit. L'invention s'applique à d'autres compositions pour les deux composants de la préforme et on modifiera selon ces compositions les paramètres de fibrage et de traitement thermique.

## Revendications

1. Procédé de réalisation par fibrage d'une fibre supraconductrice à haute température critique en un matériau de la famille Biₓ Pb_{y} Sr₂ Ca₂ Cu₃ O_{z} avec 1,9 ≦ x+y ≦ 2,3, procédé selon lequel on réalise une préforme, un fibrage et un recuit sous air de la fibre obtenue, et caractérisé par le fait que ladite préforme est constituée d'un bloc (1) en matériau vitreux de formule Biₓ Pb_{y} Sr₂ Ca₂ Cu₃ O_{z} avec 1,9 ≦ x+y ≦ 2,3 et d'un tube (2) entourant ledit bloc en un matériau vitreux de formule Bi_{x′} Sr₂ Ca₁ Cu₂ O_{z′} avec 1,5 ≦ x′ ≦ 2,2.

2. Procédé selon la revendication 1, caractérisé par le fait que ledit recuit sous air est mené à 840°C pendant 200 heures.

3. Fibre supraconductrice obtenue par le procédé selon la revendication 1, caractérisée par le fait qu'elle comprend :
- un coeur en matériau supraconducteur à une température critique supérieure à 90K, dont la formule est Biₓ Pb_{y} Sr₂ Ca₂ Cu₃ O_{z} avec 1,9 ≦ x+y ≦ 2,3,
- une gaine en matériau supraconducteur à une température critique inférieure à 77k et dont la formule est Bi_{x′} Sr₂ Ca₁ Cu₂ O_{z′} avec 1,5 ≦ x′ ≦ 2,2.

## Patentansprüche

1. Faserziehverfahren zur Herstellung einer supraleitenden Faser mit hoher kritischer Temperatur aus einem Material der Familie BiₓPb_{y}Sr₂Ca₂Cu₃O_{z}, mit 1,9≦x+y≦2,3, wobei man einen Rohling herstellt, eine Faser zieht und diese erhaltene Faser an Luft tempert, dadurch gekennzeichnet, daß der Rohling aus einem Block aus Glasmaterial der Formel BiₓPb_{y}Sr₂Ca₂Cu₃O_{z} mit 1,9≦x+y≦2,3 und einem diesen Block umgebenden Rohr aus einem Glasmaterial der Formel Bi_{x′}Sr₂Ca₁Cu₂O_{z} mit 1,5≦x′≦2,2 besteht.

2. Verfahren nach Anspruch 1, dadurch gekennzeichnet, daß das Tempern an Luft während 200 Stunden bei 840°C durchgeführt wird.

3. Supraleitende Faser, die durch das Verfahren gemäß Anspruch 1 erhalten wird, dadurch gekennzeichnet, daß sie aufweist:
- einen Kern aus supraleitendem Material mit einer kritischen Temperatur oberhalb 90K, deren Formel BiₓPb_{y}Sr₂Ca₂Cu₃O_{z} mit 1,9≦x+y≦2,3 lautet,
- eine Hülle aus supraleitendem Material mit einer kritischen Temperatur unterhalb 77K, deren Formel Bi_{x′}Sr₂Ca₁Cu₂O_{z} mit 1,5≦x′≦2,2 lautet.

## Claims

1. A method of making a high critical temperature superconductive fiber by fiber-drawing a material of the family Biₓ Pb_{y} Sr₂ Ca₂ Cu₃ O_{z} where 1·9 ≦ x+y ≦ 2·3, in which method a preform is made, fiber drawing is performed, and the resulting fiber is annealed in air, the method being characterized by the fact that said preform is constituted by a block (1) of vitreous material having the formula Biₓ Pb_{y} Sr₂ Ca₂ Cu₃ O_{z} where: 1·9 ≦ x+y ≦ 2·3 and a tube (2) surrounding said block and made of a vitreous material having the formula Bi_{x′}Sr₂ Ca₁ Cu₂ O_{z′} with 1·5 ≦ x′ ≦ 2·2.

2. A method according to claim 1, characterized by the fact that said annealing in air is performed at 840°C for 200 hours.

3. A superconductive fiber obtained by the method of claim 1, characterized by the fact that the fiber comprises:
a core of superconductive material having a critical temperature greater than 90K, whose formula is Biₓ Pb_{y} Sr₂ Ca₂ Cu₃ O_{z} with 1·9 ≦ x+y ≦ 2·3; and
a sheath of superconducting material having a critical temperature of less than 77K, and whose formula is Bi_{x′} Sr₂ Ca₁ Cu₂ O_{z′} with 1·5 ≦ x′ ≦ 2·2.
